# EUROPEAN PATENT APPLICATION

(11) **EP 4 067 917 A1**
(43) Date of publication of application: **05.10.2022**
(21) Application number: 21901688.8
(22) Date of filing: 07.07.2021
(51) Int. Cl.: G01R 31/28

(54) **LATCH-UP TESTING STRUCTURE FOR INTEGRATED CIRCUIT**

(30) Priority: 03.02.2021 CN 202110149970
(71) Applicant: Changxin Memory Technologies, Inc., Hefei City, Anhui 230000 (CN)
(72) Inventor: XU, Qi'an, Hefei Anhui 230000 (CN)
(74) Representative: Lavoix
(86) International application number: PCT/CN2021/104986
(87) International publication number: WO 2022/166105

(57) **Abstract**

Embodiment provides an integrated circuit latch-up test structure. The circuit includes: a first P-type heavily doped region, a first N-type heavily doped region, a second P-type heavily doped region, and a second N-type heavily doped region. The first P-type heavily doped region and the first N-type heavily doped region are both located on a P-type substrate, the second P-type heavily doped region and the second N-type heavily doped region are both located in an N-well, and the N-well is located on the P-type substrate. A first distance is provided between the first P-type heavily doped region and the first N-type heavily doped region, a second distance is provided between the first N-type heavily doped region and the second P-type heavily doped region, and a third distance is provided between the second P-type heavily doped region and the second N-type heavily doped region. The test structure is configured to test electrical parameters of a latch-up effect of an integrated circuit corresponding to the test structure by adjusting at least one of the first distance, the second distance, and the third distance.

## Description

### CROSS REFERENCE TO RELATED APPLICATION

This application claims priority to Chinese Patent Application No. 202110149970.8 titled "INTEGRATED CIRCUIT LATCH-UP TEST STRUCTURE" and filed to the State Intellectual Property Office on February 03, 2021, the entire contents of which are incorporated herein by reference.

### TECHNICAL FIELD

The present disclosure relates to the technical field of integrated circuits, and in particular to an integrated circuit latch-up test structure.

### BACKGROUND

As a parasitic effect unique to Complementary Metal-Oxide-Semiconductor Transistor (CMOS) technologies, a latch-up effect may seriously cause failure of circuits and even burn out chips. The latch-up effect is produced by an n-p-n-p structure comprising an active region of an N-channel metal oxide semiconductor (NMOS), a P-type substrate, an N-well and a P-channel metal oxide semiconductor (PMOS). When one of triodes is positively biased, a positive feedback may be constituted, and latch-up may be formed. As an invisible destructive force, static electricity may have a negative effect on electronic components. Either of the static electricity and related voltage transients may cause the latch-up effect, which is one of primary reasons for the failure of semiconductor devices. The positive feedback may be formed when the latch-up effect occurs. In this case, short circuits of semiconductor components may be formed between power cords and earth wires, which may cause large current, electrical overstress, and even damage to the semiconductor components.

To ensure reliability of the chips, it is required to avoid occurrence of the latch-up effect in integrated circuits. Therefore, in a development stage of the chips, it is necessary to complete the design of the integrated circuits by testing electrical parameters of the integrated circuits in the event of the latch-up effect, to avoid the occurrence of the latch-up effect.

### SUMMARY

The present disclosure provides an integrated circuit latch-up test structure, which includes:
a first P-type heavily doped region, a first N-type heavily doped region, a second P-type heavily doped region, and a second N-type heavily doped region.

The first P-type heavily doped region and the first N-type heavily doped region are both located on a P-type substrate, the second P-type heavily doped region and the second N-type heavily doped region both are located in an N-well, and the N-well is located on the P-type substrate.

A first distance is provided between the first P-type heavily doped region and the first N-type heavily doped region, a second distance is provided between the first N-type heavily doped region and the second P-type heavily doped region, and a third distance is provided between the second P-type heavily doped region and the second N-type heavily doped region.

The test structure is configured to test an electrical parameter of a latch-up effect of an integrated circuit corresponding to the test structure by adjusting at least one of the first distance, the second distance, and the third distance.

The present disclosure also provides an integrated circuit latch-up test structure, which includes:
a first P-type heavily doped region, a first N-type heavily doped region, a second P-type heavily doped region, and a second N-type heavily doped region.

The first P-type heavily doped region is located on a P-type substrate, the first N-type heavily doped region is located in a first N-well, the second P-type heavily doped region and the second N-type heavily doped region both are located in a second N-well, and the first N-well and the second N-well both are located on the P-type substrate.

A first distance is provided between the first P-type heavily doped region and the first N-type heavily doped region, a second distance is provided between the first N-type heavily doped region and the second P-type heavily doped region, and a third distance is provided between the second P-type heavily doped region and the second N-type heavily doped region.

The test structure is configured to test an electrical parameter of a latch-up effect of an integrated circuit corresponding to the test structure by adjusting at least one of the first distance, the second distance, and the third distance.

The present disclosure also provides an integrated circuit latch-up test structure, which includes:
a first P-type heavily doped region, a first N-type heavily doped region, a second P-type heavily doped region, and a second N-type heavily doped region.

The first P-type heavily doped region is located on a P-type substrate, the first N-type heavily doped region is located in a deep N-well, the deep N-well is located in a first N-well, the second P-type heavily doped region and the second N-type heavily doped region both are located in a second N-well, and the first N-well and the second N-well both are located on the P-type substrate.

A first distance is provided between the first P-type heavily doped region and the first N-type heavily doped region, a second distance is provided between the first N-type heavily doped region and the second P-type heavily doped region, and a third distance is provided between the second P-type heavily doped region and the second N-type heavily doped region.

The test structure is configured to test an electrical parameter of a latch-up effect of an integrated circuit corresponding to the test structure by adjusting at least one of the first distance, the second distance, and the third distance.

The present disclosure also provides an integrated circuit latch-up test structure, which includes:
a first N-type heavily doped region, a first P-type heavily doped region, a second N-type heavily doped region, and a second P-type heavily doped region.

The first N-type heavily doped region and the first P-type heavily doped region are both located in a deep N-well, the deep N-well is located in an N-well, and the N-well is located on a P-type substrate.

The second N-type heavily doped region and the second P-type heavily doped region are both located in a P-well, and the P-well is located in the deep N-well.

A first distance is provided between the first N-type heavily doped region and the first P-type heavily doped region, a second distance is provided between the first P-type heavily doped region and the second N-type heavily doped region, and a third distance is provided between the second N-type heavily doped region and the second P-type heavily doped region.

The test structure is configured to test an electrical parameter of a latch-up effect of an integrated circuit corresponding to the test structure by adjusting at least one of the first distance, the second distance, and the third distance.

The present disclosure also provides an integrated circuit latch-up test structure, which includes:
a first N-type heavily doped region, a first P-type heavily doped region, a second N-type heavily doped region, and a second P-type heavily doped region.

The first N-type heavily doped region is located in an N-well, and the N-well is located on a P-type substrate.

The first P-type heavily doped region is located in a P-well, the P-well is located in a deep N-well, and the deep N-well is located in the N-well.

The second N-type heavily doped region and the second P-type heavily doped region both are located on the P-type substrate.

A first distance is provided between the first N-type heavily doped region and the first P-type heavily doped region, a second distance is provided between the first P-type heavily doped region and the second N-type heavily doped region, and a third distance is provided between the second N-type heavily doped region and the second P-type heavily doped region.

The test structure is configured to test an electrical parameter of a latch-up effect of an integrated circuit corresponding to the test structure by adjusting at least one of the first distance, the second distance, and the third distance.

The present disclosure also provides an integrated circuit latch-up test structure, which includes:
a first N-type heavily doped region, a first P-type heavily doped region, a second N-type heavily doped region, and a second P-type heavily doped region.

The first N-type heavily doped region is located in a first N-well, and the first N-well is located on a P-type substrate.

The first P-type heavily doped region is located in a P-well, the P-well is located in a deep N-well, and the deep N-well is located in the first N-well.

The second N-type heavily doped region is located in a second N-well, and the second N-well is located on the P-type substrate.

The second P-type heavily doped region is located on the P-type substrate.

A first distance is provided between the first N-type heavily doped region and the first P-type heavily doped region, a second distance is provided between the first P-type heavily doped region and the second N-type heavily doped region, and a third distance is provided between the second N-type heavily doped region and the second P-type heavily doped region.

The test structure is configured to test an electrical parameter of a latch-up effect of an integrated circuit corresponding to the test structure by adjusting at least one of the first distance, the second distance, and the third distance.

The present disclosure also provides an integrated circuit latch-up test structure, which includes:
a first N-type heavily doped region, a first P-type heavily doped region, a second N-type heavily doped region, and a second P-type heavily doped region.

The first N-type heavily doped region is located in a first N-well, and the first N-well is located on a P-type substrate.

The first P-type heavily doped region is located in a P-well, the P-well is located in a first deep N-well, and the first deep N-well is located in the first N-well.

The second N-type heavily doped region is located in a second deep N-well, the second deep N-well is located in a second N-well, and the second N-well is located on the P-type substrate.

The second P-type heavily doped region is located on the P-type substrate.

A first distance is provided between the first N-type heavily doped region and the first P-type heavily doped region, a second distance is provided between the first P-type heavily doped region and the second N-type heavily doped region, and a third distance is provided between the second N-type heavily doped region and the second P-type heavily doped region.

The test structure is configured to test an electrical parameter of a latch-up effect of an integrated circuit corresponding to the test structure by adjusting at least one of the first distance, the second distance, and the third distance.

The present disclosure provides an integrated circuit latch-up test structure. In this test structure, an electrical parameter of a latch-up effect of an integrated circuit corresponding to the integrated circuit latch-up test structure may be tested by adjusting at least one of the first distance, the second distance, and the third distance. In this way, the first distance, the second distance and the third distance in an integrated circuit corresponding to the integrated circuit latch-up test structure may be set by means of the electrical parameter of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

### BRIEF DESCRIPTION OF THE DRAWINGS

FIG. 1 is a schematic diagram of an application scenario of an integrated circuit latch-up test structure according to the present disclosure;
FIG. 2 is a top view of an integrated circuit latch-up test structure according to an embodiment of the present disclosure;
FIG. 3 is a sectional view of an integrated circuit latch-up test structure according to an embodiment of the present disclosure;
FIG. 4 is a schematic connection diagram of the integrated circuit latch-up test structures as shown in FIG. 2 and FIG. 3 when in test;
FIG. 5 is a top view of an integrated circuit latch-up test structure according to an embodiment of the present disclosure;
FIG. 6 is a sectional view of an integrated circuit latch-up test structure according to an embodiment of the present disclosure;
FIG. 7 is a schematic connection diagram of the integrated circuit latch-up test structures as shown in FIG. 5 and FIG. 6 when in test;
FIG. 8 is a top view of an integrated circuit latch-up test structure according to an embodiment of the present disclosure;
FIG. 9 is a sectional view of an integrated circuit latch-up test structure according to an embodiment of the present disclosure;
FIG. 10 is a schematic connection diagram of the integrated circuit latch-up test structures as shown in FIG. 8 and FIG. 9 when in test;
FIG. 11 is a top view of an integrated circuit latch-up test structure according to an embodiment of the present disclosure;
FIG. 12 is a sectional view of an integrated circuit latch-up test structure according to an embodiment of the present disclosure;
FIG. 13 is a schematic connection diagram of the integrated circuit latch-up test structures as shown in FIG. 11 and FIG. 12 when in test;
FIG. 14 is a top view of an integrated circuit latch-up test structure according to an embodiment of the present disclosure;
FIG. 15 is a sectional view of an integrated circuit latch-up test structure according to an embodiment of the present disclosure;
FIG. 16 is a schematic connection diagram of the integrated circuit latch-up test structures as shown in FIG. 14 and FIG. 15 when in test;
FIG. 17 is a top view of an integrated circuit latch-up test structure according to an embodiment of the present disclosure;
FIG. 18 is a sectional view of an integrated circuit latch-up test structure according to an embodiment of the present disclosure;
FIG. 19 is a schematic connection diagram of the integrated circuit latch-up test structures as shown in FIG. 17 and FIG. 18 when in test;
FIG. 20 is a top view of an integrated circuit latch-up test structure according to an embodiment of the present disclosure;
FIG. 21 is a sectional view of an integrated circuit latch-up test structure according to an embodiment of the present disclosure; and
FIG. 22 is a schematic connection diagram of the integrated circuit latch-up test structures as shown in FIG. 20 and FIG. 21 when in test.

### DETAILED DESCRIPTION

Technical solutions in embodiments of the present disclosure are described below clearly and completely with reference to the drawings in the embodiments of the present disclosure. Apparently, the described embodiments are merely part rather than all of the embodiments of the present disclosure. All other embodiments obtained by those skilled in the art based on the embodiments of the present disclosure without creative efforts should fall within the protection scope of the present disclosure.

It should be explained that in the specification, the claims and the foregoing accompanying drawings of the present disclosure, a term such as "first" or "second" is intended to separate between similar objects but is not intended to describe a particular sequence or precedence order. It is to be understood that data used like this may be interchangeable where appropriate, so that the embodiments of the present disclosure described herein can be implemented in sequences excluding those illustrated or described herein.

Furthermore, terms such as "comprise", "have" or other variants thereof are intended to cover a non-exclusive "comprise", for example, processes, methods, systems, products or devices comprising a series of steps or units are not limited to these steps or units listed explicitly, but comprise other steps or units not listed explicitly, or other steps or units inherent to these processes, methods, systems, products or devices.

To ensure the reliability of a chip, in a development stage of the chip, it is necessary to complete the design of an integrated circuit by testing electrical parameters of the integrated circuit in the event of a latch-up effect, to avoid the occurrence of the latch-up effect. To solve this problem, the present disclosure provides an integrated circuit latch-up test structure. The test structure includes a first P-type heavily doped region, a first N-type heavily doped region, a second P-type heavily doped region, and a second N-type heavily doped region. A first distance is provided between the first P-type heavily doped region and the first N-type heavily doped region, a second distance is provided between the first N-type heavily doped region and the second P-type heavily doped region, and a third distance is provided between the second P-type heavily doped region and the second N-type heavily doped region. In different integrated circuit latch-up test structures, the first P-type heavily doped regions, the first N-type heavily doped regions, the second P-type heavily doped regions and the second N-type heavily doped regions are arranged on different locations. Electrical parameters of a latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and the chip is prevented from being burned out due to the latch-up effect, such that the reliability of the chip is improved.

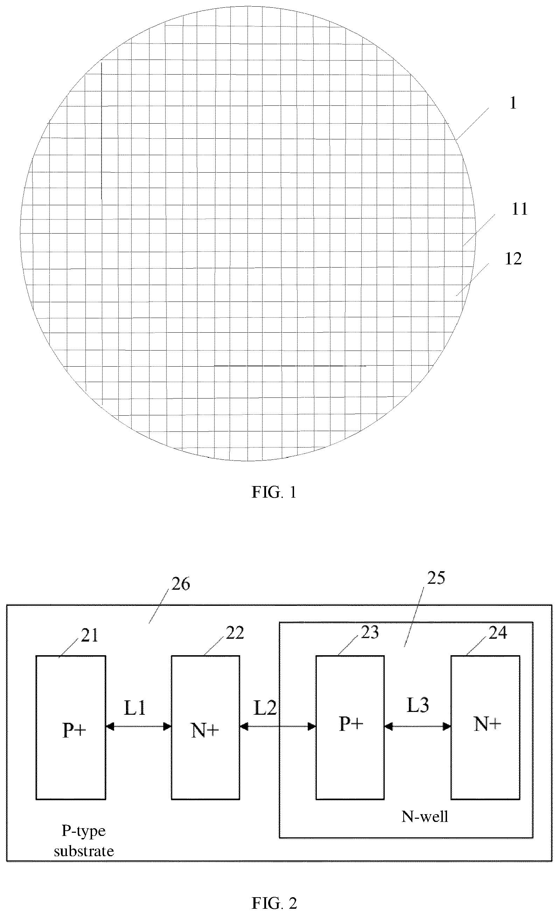

FIG. 1 is a schematic diagram of an application scenario of an integrated circuit latch-up test structure according to the present disclosure. As shown in FIG. 1, the application scenario of the integrated circuit latch-up test structure provided by the present disclosure involves a wafer 1 and the integrated circuit latch-up test structure, a plurality of bare dies 12 and scribe lines 11 are formed after the wafer 1 is cut, wherein the integrated circuit latch-up test structure may be located on the wafer 1. In some embodiments, the integrated circuit latch-up test structure may be located in the scribe lines 11 or the bare dies 12. The integrated circuit on the bare dies 12 has the same as an equivalent circuit corresponding to the integrated circuit latch-up test structure. Electrical parameters of the latch-up effect of the integrated circuit on the bare dies 12 are tested by the integrated circuit latch-up test structure. The electrical parameters include a trigger voltage for triggering the latch-up effect, a holding voltage for holding the latch-up effect, a trigger current for triggering the latch-up effect, and a holding current for holding the latch-up effect. The trigger voltage is greater, the latch-up is less likely to cause; and the holding voltage is greater, the latch-up effect is less likely to hold. Supposing a normal working voltage is 1.1V, a risk of triggering the latch-up effect is greater if the trigger voltage is 1.2V. However, the risk of triggering the latch-up effect is smaller if the trigger voltage is 2V. Similarly, the holding voltage has the same principle. It is to be noted that the holding voltage generally is smaller than the trigger voltage. For example, the trigger voltage is 2V, and the holding voltage may be 1.8V

The integrated circuit latch-up test structure includes a first P-type heavily doped region, a first N-type heavily doped region, a second P-type heavily doped region, and a second N-type heavily doped region. A first distance is provided between the first P-type heavily doped region and the first N-type heavily doped region, a second distance is provided between the first N-type heavily doped region and the second P-type heavily doped region, and a third distance is provided between the second P-type heavily doped region and the second N-type heavily doped region. In different integrated circuit latch-up test structures, the first P-type heavily doped regions, the first N-type heavily doped regions, the second P-type heavily doped regions and the second N-type heavily doped regions are arranged on different locations. The first distance, the second distance and the third distance are related to the trigger voltage for triggering the latch-up effect, the holding voltage for holding the latch-up effect, the trigger current for triggering the latch-up effect, and the holding current for holding the latch-up effect. The electrical parameters (i.e., the trigger voltage for triggering the latch-up effect, the holding voltage for holding the latch-up effect, the trigger current for triggering the latch-up effect, and the holding current for holding the latch-up effect) of the latch-up effect of the integrated circuit corresponding to the integrated circuit latch-up test structure may be tested by adjusting at least one of the first distance, the second distance, and the third distance. In this way, the first distance, the second distance and the third distance in the integrated circuit on the dare dies 12 may be set by the electrical parameters of the latch-up effect and the first distance, the second distance, and the third distance. Thus, occurrence of the latch-up effect can be prevented in a working process of the integrated circuit on the dare dies 12, and the chip is prevented from being burned out due to the latch-up effect, the reliability of the chip is improved.

In some embodiments, various corresponding integrated circuit latch-up test structures may also be designed by changing magnitudes of the first distance, the second distance, and the third distance. The electrical parameters (also referred to as latch-up characteristics) of the latch-up effect of this integrated circuit latch-up test structure may be evaluated based on a transmission line pulse (TLP) test. In this way, related latch-up design rules may be defined based on the latch-up characteristics, such that reliability of the integrated circuit can be ensured.

A structure of the integrated circuit latch-up test structure provided in the present disclosure is described in detail below with reference to some embodiments. FIGS. 2 to 22 illustrate seven types of integrated circuit latch-up test structures in total. In different integrated circuit latch-up test structures, the first P-type heavily doped regions, the first N-type heavily doped regions, the second P-type heavily doped regions and the second N-type heavily doped regions are arranged on different locations. It is to be noted that in FIGS. 2 to 22, the P-type heavily doped region is referred to as P+, and the N-type heavily doped region is referred to as N+.

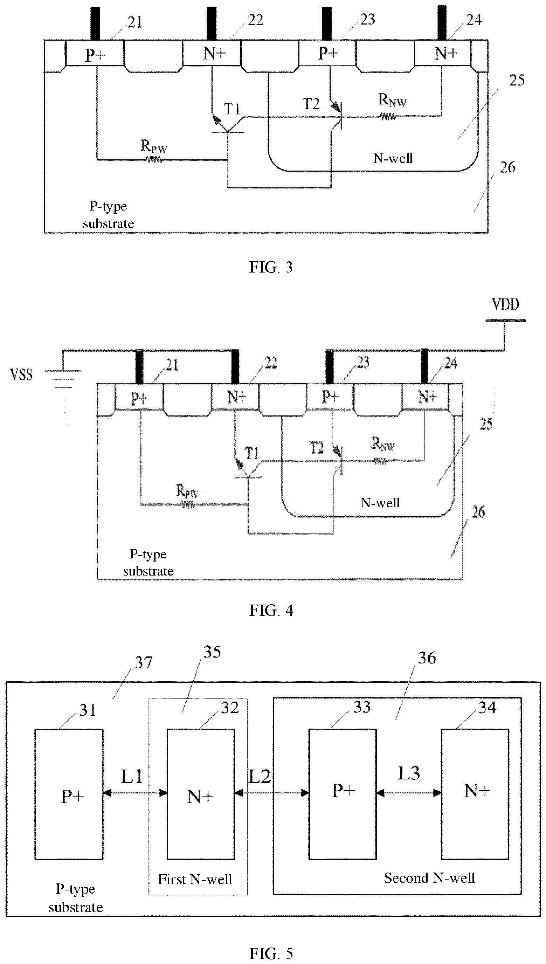

FIG. 2 is a top view of an integrated circuit latch-up test structure according to an embodiment of the present disclosure, and FIG. 3 is a sectional view of an integrated circuit latch-up test structure according to an embodiment of the present disclosure. With reference to FIG. 2 and FIG. 3, the integrated circuit latch-up test structure of this embodiment may include: a first P-type heavily doped region 21, a first N-type heavily doped region 22, a second P-type heavily doped region 23, and a second N-type heavily doped region 24.

The first P-type heavily doped region 21 and the first N-type heavily doped region 22 are both located on a P-type substrate, the second P-type heavily doped region 23 and the second N-type heavily doped region 24 are both located in an N-well 25, and the N-well 25 is located on the P-type substrate 26.

A first distance L1 is provided between the first P-type heavily doped region 21 and the first N-type heavily doped region 22, a second distance L2 is provided between the first N-type heavily doped region 22 and the second P-type heavily doped region 23, and a third distance L3 is provided between the second P-type heavily doped region 23 and the second N-type heavily doped region 24.

The test structure is configured to test electrical parameters of a latch-up effect of an integrated circuit corresponding to the test structure by adjusting at least one of the first distance L1, the second distance L2, and the third distance L3.

Further, as shown in FIG. 3, the N-well 25, the P-type substrate 26 and the first N-type heavily doped region 22 constitute a first parasitic NPN transistor T1. The second P-type heavily doped region 23, the N-well 25 and the P-type substrate 26 constitute a first parasitic PNP transistor T2.

The P-type substrate 26 has a first parasitic resistor RPW, wherein a first terminal of the first parasitic resistor RPW is connected to the first P-type heavily doped region, and a second terminal of the first parasitic resistor RPW is connected to a base of the first parasitic NPN transistor T1.

The N-well 25 has a second parasitic resistor RNW, wherein a first terminal of the second parasitic resistor RNW is connected to the second N-type heavily doped region 24, and a second terminal of the second parasitic resistor RNW is connected to a base of the first parasitic PNP transistor T2.

Test principles of the integrated circuit latch-up test structure as shown in FIG. 2 and FIG. 3 are described below with reference to FIG. 4. FIG. 4 is a schematic connection diagram of the integrated circuit latch-up test structures as shown in FIG. 2 and FIG. 3 when in test. As shown in FIG. 4, before the test, the first P-type heavily doped region 21 and the first N-type heavily doped region 22 are both connected to a ground terminal VSS, and the second P-type heavily doped region 23 and the second N-type heavily doped region 24 are both connected to a power supply terminal VDD. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 2 and FIG. 3, to avoid the latch-up effect in a working process of the integrated circuit corresponding to the integrated circuit latch-up test structure. For example, the corresponding table can be in the form shown in Table 1 below.

**Table 1**

| | |
|---|---|
| The first group distance (including the first distance L1, the second distance L2, and the third distance L3) | The trigger voltage for triggering the latch-up effect, the holding voltage for holding the latch-up effect, the trigger current for triggering the latch-up effect, and the holding current for holding the latch-up effect |
| The second group distance (including the first distance L1, the second distance L2, and the third distance L3) | The trigger voltage for triggering the latch-up effect, the holding voltage for holding the latch-up effect, the trigger current for triggering the latch-up effect, and the holding current for holding the latch-up effect |
| The third group distance (including the first distance L1, the second distance L2, and the third distance L3) | The trigger voltage for triggering the latch-up effect, the holding voltage for holding the latch-up effect, the trigger current for triggering the latch-up effect, and the holding current for holding the latch-up effect |
| The Nth group of distance (including the first distance L1, the second distance L2, and the third distance L3) | The trigger voltage for triggering the latch-up effect, the holding voltage for holding the latch-up effect, the trigger current for triggering the latch-up effect, and the holding current for holding the latch-up effect |

The principle of the latch-up effect is described below. In some embodiments, T2 is a vertical PNP transistor, a base is an N-well, and a gain from the base to a collector may be up to dozens of times. T1 is a side NPN transistor, a base is a P-type substrate, and a gain from the base to a collector may be up to dozens of times. RNW is a parasitic resistor of the N-well, and RPW is a parasitic resistor of the P-type substrate.

The above four components T1, T2, RNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, it will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of the integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

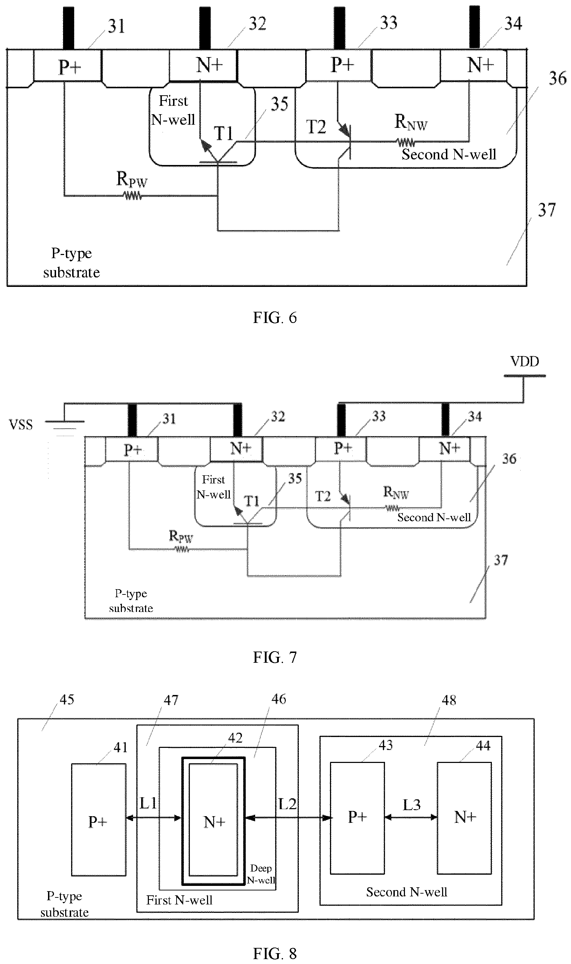

FIG. 5 is a top view of an integrated circuit latch-up test structure according to an embodiment of the present disclosure, and FIG. 6 is a sectional view of an integrated circuit latch-up test structure according to an embodiment of the present disclosure. With reference to FIG. 5 and FIG. 6, the integrated circuit latch-up test structure of this embodiment may include: a first P-type heavily doped region 31, a first N-type heavily doped region 32, a second P-type heavily doped region 33, and a second N-type heavily doped region 34.

The first P-type heavily doped region 31 is located on a P-type substrate 37, the first N-type heavily doped region 32 is located in a first N-well 35, the second P-type heavily doped region and the second N-type heavily doped region 34 both are located in a second N-well 36, and the first N-well 35 and the second N-well 36 both are located on the P-type substrate 37.

The first distance L1 is provided between the first P-type heavily doped region 31 and the first N-type heavily doped region 32, the second distance L2 is provided between the first N-type heavily doped region 32 and the second P-type heavily doped region 33, and the third distance L3 is provided between the second P-type heavily doped region 33 and the second N-type heavily doped region 34.

The test structure is configured to test the electrical parameters of the latch-up effect of the integrated circuit corresponding to the test structure by adjusting at least one of the first distance L1, the second distance L2, and the third distance L3.

Further, as shown in FIG. 6, the second N-well 36, the P-type substrate 37 and the first N-type heavily doped region 32 constitute the first parasitic NPN transistor T1. The second P-type heavily doped region 33, the second N-well 36 and the P-type substrate 37 constitute the first parasitic PNP transistor T2.

The P-type substrate 37 has a first parasitic resistor RPW, wherein a first terminal of the first parasitic resistor RPW is connected to the first P-type heavily doped region 31, and a second terminal of the first parasitic resistor RPW is connected to a base of the first parasitic NPN transistor T1.

The second N-well 36 has a second parasitic resistor RNW, wherein a first terminal of the second parasitic resistor RNW is connected to the second N-type heavily doped region 34, and a second terminal of the second parasitic resistor RNW is connected to a base of the first parasitic PNP transistor T2.

Test principles of the integrated circuit latch-up test structure as shown in FIG. 5 and FIG. 6 are described below with reference to FIG. 7. FIG. 7 is a schematic connection diagram of the integrated circuit latch-up test structures as shown in FIG. 5 and FIG. 6 when in test. As shown in FIG. 7, before the test, the first P-type heavily doped region 31 and the first N-type heavily doped region 32 are both connected to a ground terminal VSS, and the second P-type heavily doped region 33 and the second N-type heavily doped region 34 are both connected to a power supply terminal VDD. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 5 and FIG. 6, to avoid the latch-up effect in a working process of the integrated circuit corresponding to the integrated circuit latch-up test structure. For example, the corresponding table can be in the form of shown in Table 1 above.

The principle of the latch-up effect is described below. In some embodiments, T2 is a vertical PNP transistor, a base is an N-well, and a gain from the base to a collector may be up to hundreds of times. T1 is a side NPN transistor, a base is a P-type substrate, and a gain from the base to a collector may be up to dozens of times. RNW is a parasitic resistor of the second N-well, and RPW is a parasitic resistor of the P-type substrate.

The above four components T1, T2, RNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, it will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

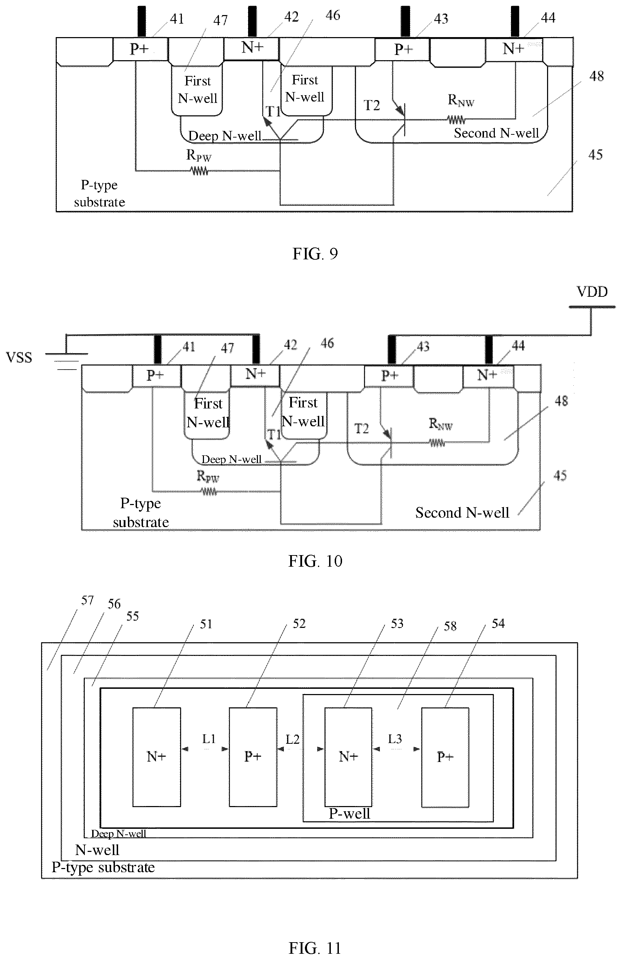

FIG. 8 is a top view of an integrated circuit latch-up test structure according to an embodiment of the present disclosure, and FIG. 9 is a sectional view of an integrated circuit latch-up test structure according to an embodiment of the present disclosure. With reference to FIG. 8 and FIG. 9, the integrated circuit latch-up test structure of this embodiment may include: a first P-type heavily doped region 41, a first N-type heavily doped region 42, a second P-type heavily doped region 43, and a second N-type heavily doped region 44.

The first P-type heavily doped region 41 is located on a P-type substrate 45, the first N-type heavily doped region 42 is located in a deep N-well 46, the deep N-well 46 is located in a first N-well 47, the second P-type heavily doped region 43 and the second N-type heavily doped region 44 both are located in a second N-well 48, and the first N-well 47 and the second N-well 48 both are located on the P-type substrate 45.

The first distance L1 is provided between the first P-type heavily doped region 41 and the first N-type heavily doped region 42, the second distance L2 is provided between the first N-type heavily doped region 42 and the second P-type heavily doped region 43, and the third distance L3 is provided between the second P-type heavily doped region 43 and the second N-type heavily doped region 44.

The test structure is configured to test the electrical parameters of the latch-up effect of the integrated circuit corresponding to the test structure by adjusting at least one of the first distance L1, the second distance L2, and the third distance L3.

Further, as shown in FIG. 9, the second N-well 48, the P-type substrate 45 and the deep N-well 46 constitute the first parasitic NPN transistor T1. The second P-type heavily doped region 43, the second N-well 48 and the P-type substrate 45 constitute the first parasitic PNP transistor T2.

The P-type substrate 45 has a first parasitic resistor RPW, wherein a first terminal of the first parasitic resistor RPW is connected to the first P-type heavily doped region 41, and a second terminal of the first parasitic resistor RPW is connected to an emitter of the first parasitic NPN transistor T1.

The second N-well 48 has a second parasitic resistor RNW, wherein a first terminal of the second parasitic resistor RNW is connected to the second N-type heavily doped region 44, and a second terminal of the second parasitic resistor RNW is connected to a base of the first parasitic PNP transistor T2.

Test principles of the integrated circuit latch-up test structure as shown in FIG. 8 and FIG. 9 are described below with reference to FIG. 10. FIG. 10 is a schematic connection diagram of the integrated circuit latch-up test structures as shown in FIG. 8 and FIG. 9 when in test. As shown in FIG. 10, before the test, the first P-type heavily doped region 41 and the first N-type heavily doped region 42 are both connected to a ground terminal VSS, and the second P-type heavily doped region 43 and the second N-type heavily doped region 44 are both connected to a power supply terminal VDD. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 8 and FIG. 9, avoid the latch-up effect in a working process of the integrated circuit corresponding to the integrated circuit latch-up test structure. For example, the corresponding table can be in the form of shown in Table 1 above.

The principle of the latch-up effect is described below. In some embodiments, T2 is a vertical PNP transistor, a base is an N-well, and a gain from the base to a collector may be up to hundreds of times. T1 is a side NPN transistor, a base is a P-type substrate, and a gain from the base to a collector may be up to dozens of times. RNW is a parasitic resistor of the second N-well, and RPW is a parasitic resistor of the P-type substrate.

The above four components T1, T2, RNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

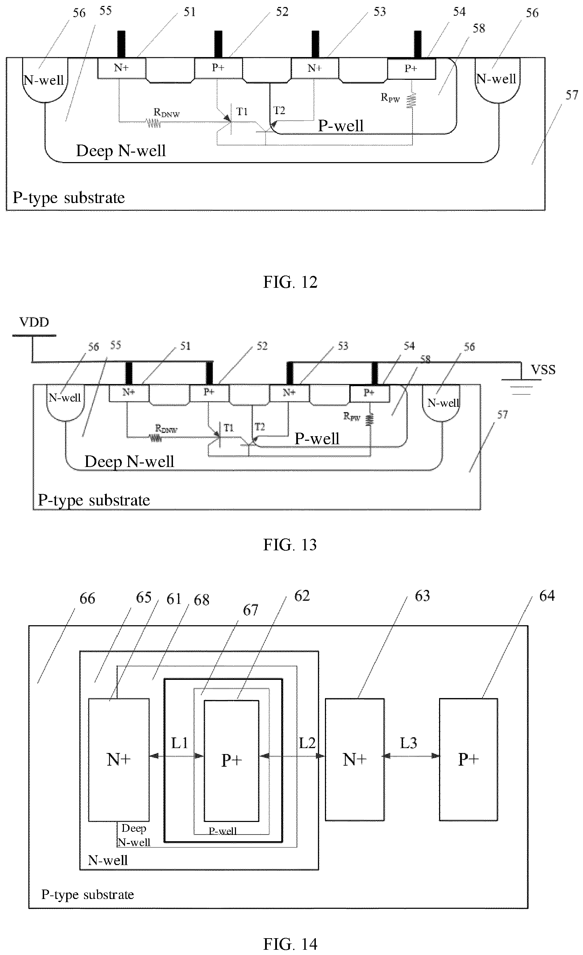

FIG. 11 is a top view of an integrated circuit latch-up test structure according to an embodiment of the present disclosure, and FIG. 12 is a sectional view of an integrated circuit latch-up test structure according to an embodiment of the present disclosure. With reference to FIG. 11 and FIG. 12, the integrated circuit latch-up test structure of this embodiment may include: a first N-type heavily doped region 51, a first P-type heavily doped region 52, a second N-type heavily doped region 53, and a second P-type heavily doped region 54.

The first N-type heavily doped region 51 and the first P-type heavily doped region 52 are both located in a deep N-well 55, the deep N-well 55 is located in an N-well 56, and the N-well 56 is located on a P-type substrate 57. The second N-type heavily doped region 53 and the second P-type heavily doped region 54 are both located in a P-well 58, and the P-well 58 is located in a deep N-well 55.

The first distance L1 is provided between the first N-type heavily doped region 51 and the first P-type heavily doped region 52, the second distance L2 is provided between the first P-type heavily doped region 52 and the second N-type heavily doped region 53, and the third distance L3 is provided between the second N-type heavily doped region 53 and the second P-type heavily doped region 54.

The test structure is configured to test the electrical parameters of the latch-up effect of the integrated circuit corresponding to the test structure by adjusting at least one of the first distance L1, the second distance L2, and the third distance L3.

Further, as shown in FIG. 12, the first P-type heavily doped region 52, the deep N-well 55 and the second P-type heavily doped region 54 constitute the first parasitic PNP transistor T1. The first N-type heavily doped region 51, the P-type substrate 57 and the deep N-well 55 constitute the first parasitic NPN transistor T2.

The deep N-well 55 has a first parasitic resistor RDNW, wherein a first terminal of the first parasitic resistor RDNW is connected to the first N-type heavily doped region, and a second terminal of the first parasitic resistor RDNW is connected to a base of the first parasitic PNP transistor T1.

The P-well 58 has a second parasitic resistor RPW, wherein a first terminal of the second parasitic resistor RPW is connected to the second P-type heavily doped region 54, and a second terminal of the second parasitic resistor RPW is connected to a base of the first parasitic NPN transistor T2 and a collector of the first parasitic PNP transistor T1.

Test principles of the integrated circuit latch-up test structure as shown in FIG. 11 and FIG. 12 are described below with reference to FIG. 13. FIG. 13 is a schematic connection diagram of the integrated circuit latch-up test structures as shown in FIG. 11 and FIG. 12 when in test. As shown in FIG. 13, before the test, the first P-type heavily doped region 52 and the first N-type heavily doped region 51 are both connected to a power supply terminal VDD, and the second P-type heavily doped region 43 and the second N-type heavily doped region 44 are both connected to a ground terminal VSS. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 11 and FIG. 12, to avoid the latch-up effect in a working process of the integrated circuit corresponding to the integrated circuit latch-up test structure. For example, the relationship table can be in the form of shown in Table 1 above.

The principle of the latch-up effect is described below. In some embodiments, T1 is a vertical PNP transistor, a base is an N-well, and a gain from the base to a collector may be up to hundreds of times. T2 is a side NPN transistor, a base is a P-type substrate, and a gain from the base to a collector may be up to dozens of times. RDNW is a parasitic resistor of the deep N-well, and RPW is a parasitic resistor of the P-well.

The above four components T1, T2, RDNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, it will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

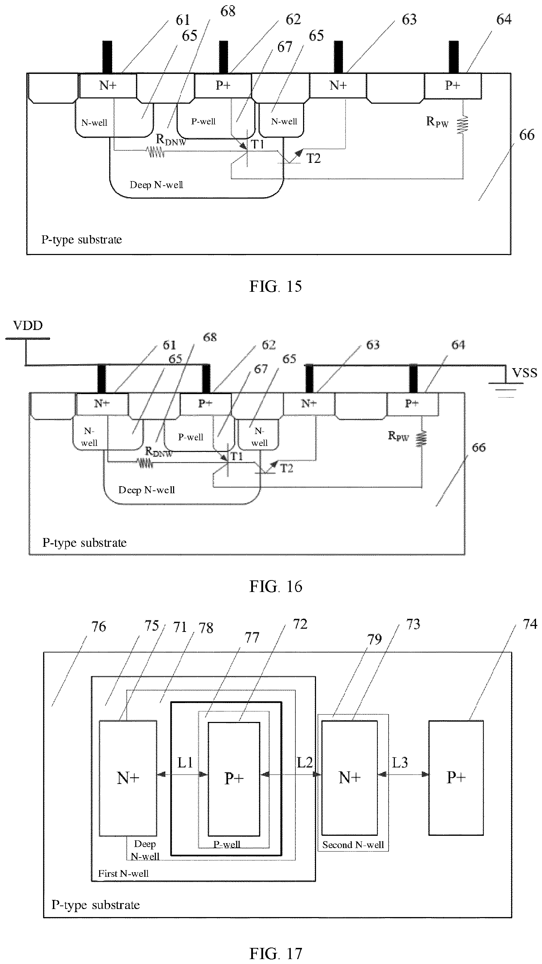

FIG. 14 is a top view of an integrated circuit latch-up test structure according to an embodiment of the present disclosure, and FIG. 15 is a sectional view of an integrated circuit latch-up test structure according to an embodiment of the present disclosure. With reference to FIG. 14 and FIG. 15, the integrated circuit latch-up test structure of this embodiment may include: a first N-type heavily doped region 61, a first P-type heavily doped region 62, a second N-type heavily doped region 63, and a second P-type heavily doped region 64.

The first N-type heavily doped region 61 is located in an N-well 65, and the N-well 65 is located on a P-type substrate 66. The first P-type heavily doped region 62 is located in a P-well 67, the P-well 67 is located in a deep N-well 68, and the deep N-well 68 is located in the N-well 65. The second N-type heavily doped region 63 and the second P-type heavily doped region 64 both are located on the P-type substrate 66.

The first distance L1 is provided between the first N-type heavily doped region 61 and the first P-type heavily doped region 62, the second distance L2 is provided between the first P-type heavily doped region 62 and the second N-type heavily doped region 63, and the third distance L3 is provided between the second N-type heavily doped region 63 and the second P-type heavily doped region 64.

The test structure is configured to test the electrical parameters of the latch-up effect of the integrated circuit corresponding to the test structure by adjusting at least one of the first distance L1, the second distance L2, and the third distance L3.

Further, as shown in FIG. 15, the P-well 67, the deep N-well 68 and the P-type substrate 66 constitute the first parasitic PNP transistor T1. The deep N-well 68, the P-type substrate 66 and the second N-type heavily doped region 63 constitute the first parasitic NPN transistor T2.

The deep N-well 68 has a first parasitic resistor RDNW, wherein a first terminal of the first parasitic resistor RDNW is connected to the first N-type heavily doped region 61, and a second terminal of the first parasitic resistor RDNW is connected to a base of the first parasitic PNP transistor T1.

The P-type substrate 66 has a second parasitic resistor RPW, wherein a first terminal of the second parasitic resistor RPW is connected to the second P-type heavily doped region 64, and a second terminal of the second parasitic resistor RPW is connected to a base of the first parasitic NPN transistor T2 and a collector of the first parasitic PNP transistor T1.

Test principles of the integrated circuit latch-up test structure as shown in FIG. 14 and FIG. 15 are described below with reference to FIG. 16. FIG. 16 is a schematic connection diagram of the integrated circuit latch-up test structures as shown in FIG. 14 and FIG. 15 when in test. As shown in FIG. 16, before the test, the first P-type heavily doped region 62 and the first N-type heavily doped region 61 are both connected to a power supply terminal VDD, and the second P-type heavily doped region 64 and the second N-type heavily doped region 63 are both connected to a ground terminal VSS. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 14 and FIG. 15, to avoid the latch-up effect in a working process of the integrated circuit corresponding to the integrated circuit latch-up test structure. For example, the relationship table can be in the form of shown in Table 1 above.

The principle of the latch-up effect is described below. In some embodiments, T1 is a vertical PNP transistor, a base is an N-well, and a gain from the base to a collector may be up to hundreds of times. T2 is a side NPN transistor, a base is a P-type substrate, and a gain from the base to a collector may be up to dozens of times. RDNW is a parasitic resistor of the deep N-well, and RPW is a parasitic resistor of the P-type substrate.

The above four components T1, T2, RDNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, it will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

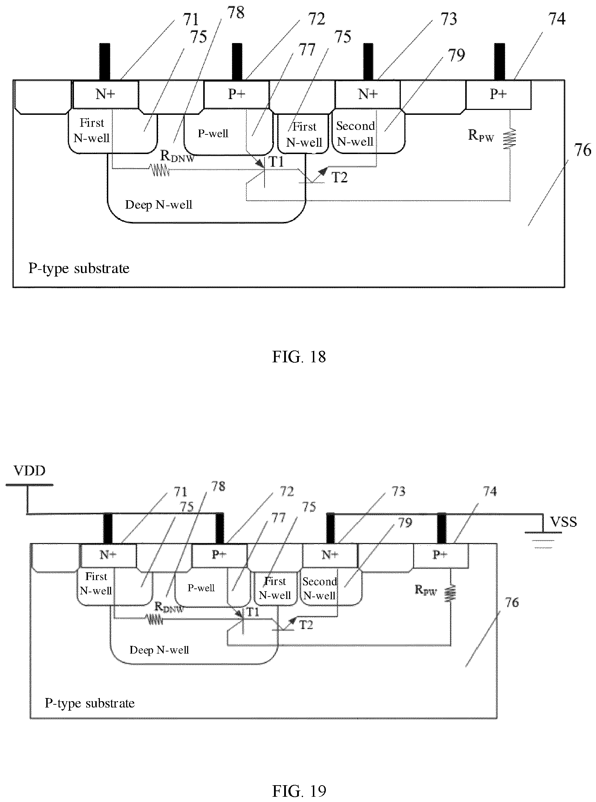

FIG. 17 is a top view of an integrated circuit latch-up test structure according to an embodiment of the present disclosure, and FIG. 18 is a sectional view of an integrated circuit latch-up test structure according to an embodiment of the present disclosure. With reference to FIG. 17 and FIG. 18, the integrated circuit latch-up test structure of this embodiment may include: a first N-type heavily doped region 71, a first P-type heavily doped region 72, a second N-type heavily doped region 73, and a second P-type heavily doped region 74.

The first N-type heavily doped region 71 is located in a first N-well 75, and the first N-well 75 is located on a P-type substrate 76. The first P-type heavily doped region 72 is located in a P-well 77, the P-well 77 is located in a deep N-well 78, and the deep N-well 78 is located in the first N-well 75. The second N-type heavily doped region 73 is located in a second N-well 79, and the second N-well 79 is located on a P-type substrate 76. The second P-type heavily doped region 74 is located on the P-type substrate 76.

The first distance L1 is provided between the first N-type heavily doped region 71 and the first P-type heavily doped region 72, the second distance L2 is provided between the first P-type heavily doped region 72 and the second N-type heavily doped region 73, and the third distance L3 is provided between the second N-type heavily doped region 73 and the second P-type heavily doped region 74.

The test structure is configured to test the electrical parameters of the latch-up effect of the integrated circuit corresponding to the test structure by adjusting at least one of the first distance L1, the second distance L2, and the third distance L3.

Further, as shown in FIG. 18, the P-well 77, the deep N-well 78 and the P-type substrate 76 constitute the first parasitic PNP transistor T1. The deep N-well 78, the P-type substrate 76 and the second N-well 79 constitute the first parasitic NPN transistor T2.

The deep N-well 78 has a first parasitic resistor RDNW, wherein a first terminal of the first parasitic resistor RDNW is connected to the first N-type heavily doped region 71, and a second terminal of the first parasitic resistor RDNW is connected to a base of the first parasitic PNP transistor T1.

The P-type substrate 76 has a second parasitic resistor RPW, wherein a first terminal of the second parasitic resistor RPW is connected to the second P-type heavily doped region 74, and a second terminal of the second parasitic resistor RPW is connected to a base of the first parasitic NPN transistor T2 and a collector of the first parasitic PNP transistor T1.

Test principles of the integrated circuit latch-up test structure as shown in FIG. 17 and FIG. 18 are described below with reference to FIG. 19. FIG. 19 is a schematic connection diagram of the integrated circuit latch-up test structures as shown in FIG. 17 and FIG. 18 when in test. As shown in FIG. 19, before the test, the first P-type heavily doped region 72 and the first N-type heavily doped region 71 are both connected to a power supply terminal VDD, and the second P-type heavily doped region 74 and the second N-type heavily doped region 73 are both connected to a ground terminal VSS. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 17 and FIG. 18, to avoid the latch-up effect in a working process of the integrated circuit corresponding to the integrated circuit latch-up test structure. For example, the relationship table can be in the form of shown in Table 1 above.

The principle of the latch-up effect is described below. In some embodiments, T1 is a vertical PNP transistor, a base is an N-well, and a gain from the base to a collector may be up to hundreds of times. T2 is a side NPN transistor, a base is a P-type substrate, and a gain from the base to a collector may be up to dozens of times. RDNW is a parasitic resistor of the deep N-well, and RPW is a parasitic resistor of the P-type substrate.

The above four components T1, T2, RDNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, it will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

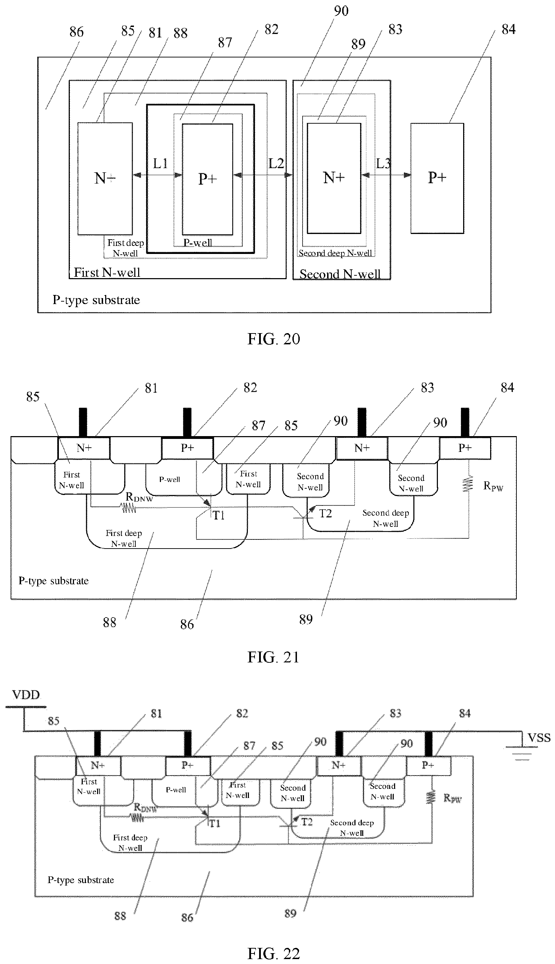

FIG. 20 is a top view of an integrated circuit latch-up test structure according to an embodiment of the present disclosure, and FIG. 21 is a sectional view of an integrated circuit latch-up test structure according to an embodiment of the present disclosure. With reference to FIG. 20 and FIG. 21, the integrated circuit latch-up test structure of this embodiment may include: a first N-type heavily doped region 81, a first P-type heavily doped region 82, a second N-type heavily doped region 83, and a second P-type heavily doped region 84.

The first N-type heavily doped region 81 is located in a first N-well 85, and the first N-well 85 is located on a P-type substrate 86. The first P-type heavily doped region 82 is located in a P-well 87, the P-well 87 is located in a first deep N-well 88, and the first deep N-well 88 is located in the first N-well 85. The second N-type heavily doped region 83 is located in a second deep N-well 89, the second deep N-well 89 is located in a second N-well 90, and the second N-well 90 is located on the P-type substrate 86. The second P-type heavily doped region 84 is located on the P-type substrate 86.

The first distance L1 is provided between the first N-type heavily doped region 81 and the first P-type heavily doped region 82, the second distance L2 is provided between the first P-type heavily doped region 82 and the second N-type heavily doped region 83, and the third distance L3 is provided between the second N-type heavily doped region 83 and the second P-type heavily doped region 84.

The test structure is configured to test the electrical parameters of the latch-up effect of the integrated circuit corresponding to the test structure by adjusting at least one of the first distance L1, the second distance L2, and the third distance L3.

Further, as shown in FIG. 21, the P-well 87, the first deep N-well 88 and the P-type substrate 86 constitute the first parasitic PNP transistor T1. The first deep N-well 88, the P-type substrate 86 and the second deep N-well 89 constitute the first parasitic NPN transistor T2.

The deep N-well 88 has a first parasitic resistor RDNW, wherein a first terminal of the first parasitic resistor RDNW is connected to the first N-type heavily doped region 81, and a second terminal of the first parasitic resistor RDNW is connected to a base of the first parasitic PNP transistor T1.

The P-type substrate 86 has a second parasitic resistor RPW, wherein a first terminal of the second parasitic resistor RPW is connected to the second P-type heavily doped region 84, and a second terminal of the second parasitic resistor RPW is connected to a base of the first parasitic NPN transistor T2 and a collector of the first parasitic PNP transistor T1.

Test principles of the integrated circuit latch-up test structure as shown in FIG. 20 and FIG. 21 are described below with reference to FIG. 22. FIG. 22 is a schematic connection diagram of the integrated circuit latch-up test structures as shown in FIG. 20 and FIG. 21 when in test. As shown in FIG. 22, before the test, the first P-type heavily doped region 82 and the first N-type heavily doped region 81 are both connected to a power supply terminal VDD, and the second P-type heavily doped region 84 and the second N-type heavily doped region 83 are both connected to a ground terminal VSS. During the test, a voltage applied to the power supply terminal VDD is gradually increased from 0V, for example, gradually increased from 0V to 5V. A current between the power supply terminal VDD and the ground terminal VSS is monitored. When the current between the power supply terminal VDD and the ground terminal VSS increases abruptly, it is determined that the latch-up effect occurs. The first distance L1, the second distance L2 and the third distance L3 are related to the trigger voltage for triggering the latch-up effect, the holding voltage for holding the latch-up effect, the trigger current for triggering the latch-up effect, and the holding current for holding the latch-up effect. In some embodiments, a corresponding relationship table between the first distance L1, the second distance L2 and the third distance L3 and the trigger voltage for triggering the latch-up effect, the holding voltage for holding the latch-up effect, the trigger current for triggering the latch-up effect, and the holding current for holding the latch-up effect may be measured. The table can be used as a basis for designing an integrated circuit corresponding to the integrated circuit latch-up test structure as shown in FIG. 20 and FIG. 21, to avoid the latch-up effect in a working process of the integrated circuit corresponding to the integrated circuit latch-up test structure. For example, the relationship table can be in the form of shown in Table 1 above.

The principle of the latch-up effect is described below. In some embodiments, T1 is a vertical PNP transistor, a base is an N-well, and a gain from the base to a collector may be up to hundreds of times. T2 is a side NPN transistor, a base is a P-type substrate, and a gain from the base to a collector may be up to dozens of times. RDNW is a parasitic resistor of the first deep N-well, and RPW is a parasitic resistor of the P-type substrate.

The above four components T1, T2, RDNW and RPW constitute a thyristor circuit. When there is no external interference or triggering, the two transistors are in an off state. A collector current has a C-B reverse leakage current, and a current gain is very small, which will not cause a latch-up. When the collector current of one of the two transistors increases abruptly to a certain value due to external interferences, it will be fed back to the other transistor, such that the two transistors are turned on due to triggering (generally, PNP is easier to trigger), and thus a low-impedance path is formed between the power supply terminal VDD and the ground terminal VSS. After that, even if the external interferences disappear, current leakage (i.e., a lock state) between the power supply terminal VDD and the ground terminal VSS may still exist due to positive feedback formed between the two triodes. This results in the latch-up effect.

This embodiment provides an integrated circuit latch-up test structure. In this test structure, electrical parameters of the latch-up effect of an integrated circuit corresponding to the integrated circuit latch-up test structure may be tested by adjusting at least one of the first distance, the second distance, and the third distance. In this way, the first distance, the second distance and the third distance in the integrated circuit corresponding to the integrated circuit latch-up test structure may be set by means of the electrical parameters of the latch-up effect and the first distance, the second distance, and the third distance. Thus, occurrence of the latch-up effect can be prevented in a working process of the integrated circuit, and a chip is prevented from being burned out due to the latch-up effect, such that reliability of the chip is improved.

Finally, it should be noted that the foregoing embodiments are used only to explain the technical solutions of the present disclosure, but are not intended to limit the present disclosure. Although the present disclosure has been described in detail with reference to the foregoing embodiments, those of ordinary skill in the art should understand that they can still modify the technical solutions described in the foregoing embodiments, or make substitutions on some or all technical features therein. The modifications or substitutions do not make the essence of the corresponding technical solutions deviate from the scope of the technical solutions of the embodiments of the present disclosure.

## Claims

1. An integrated circuit latch-up test structure, comprising:
a first P-type heavily doped region, a first N-type heavily doped region, a second P-type heavily doped region, and a second N-type heavily doped region;
wherein the first P-type heavily doped region and the first N-type heavily doped region are both located on a P-type substrate, the second P-type heavily doped region and the second N-type heavily doped region both being located in an N-well, and the N-well being located on the P-type substrate;
a first distance being provided between the first P-type heavily doped region and the first N-type heavily doped region, a second distance being provided between the first N-type heavily doped region and the second P-type heavily doped region, and a third distance being provided between the second P-type heavily doped region and the second N-type heavily doped region; and
the test structure being configured to test an electrical parameter of a latch-up effect of an integrated circuit corresponding to the test structure by adjusting at least one of the first distance, the second distance, and the third distance.

2. The integrated circuit latch-up test structure according to claim 1, wherein the N-well, the P-type substrate and the first N-type heavily doped region constitute a first parasitic NPN transistor; and
the second P-type heavily doped region, the N-well and the P-type substrate constitute a first parasitic PNP transistor.

3. The integrated circuit latch-up test structure according to claim 2, wherein the P-type substrate has a first parasitic resistor, a first terminal of the first parasitic resistor being connected to the first P-type heavily doped region, a second terminal of the first parasitic resistor being connected to a base of the first parasitic NPN transistor; and
the N-well has a second parasitic resistor, a first terminal of the second parasitic resistor being connected to the second N-type heavily doped region, and a second terminal of the second parasitic resistor being connected to a base of the first parasitic PNP transistor.

4. An integrated circuit latch-up test structure, comprising:
a first P-type heavily doped region, a first N-type heavily doped region, a second P-type heavily doped region, and a second N-type heavily doped region;
wherein the first P-type heavily doped region is located on a P-type substrate, the first N-type heavily doped region being located in a first N-well, the second P-type heavily doped region and the second N-type heavily doped region both being located in a second N-well, and the first N-well and the second N-well both being located on the P-type substrate;
a first distance being provided between the first P-type heavily doped region and the first N-type heavily doped region, a second distance being provided between the first N-type heavily doped region and the second P-type heavily doped region, and a third distance being provided between the second P-type heavily doped region and the second N-type heavily doped region; and
the test structure being configured to test an electrical parameter of a latch-up effect of an integrated circuit corresponding to the test structure by adjusting at least one of the first distance, the second distance, and the third distance.

5. The integrated circuit latch-up test structure according to claim 4, wherein the second N-well, the P-type substrate and the first N-type heavily doped region constitute a first parasitic NPN transistor; and
the second P-type heavily doped region, the second N-well and the P-type substrate constitute a first parasitic PNP transistor.

6. The integrated circuit latch-up test structure according to claim 5, wherein the P-type substrate has a first parasitic resistor, a first terminal of the first parasitic resistor being connected to the first P-type heavily doped region, a second terminal of the first parasitic resistor being connected to a base of the first parasitic NPN transistor; and
the second N-well has a second parasitic resistor, a first terminal of the second parasitic resistor being connected to the second N-type heavily doped region, and a second terminal of the second parasitic resistor being connected to a base of the first parasitic PNP transistor.

7. An integrated circuit latch-up test structure, comprising:
a first P-type heavily doped region, a first N-type heavily doped region, a second P-type heavily doped region, and a second N-type heavily doped region;
wherein the first P-type heavily doped region is located on a P-type substrate, the first N-type heavily doped region being located in a deep N-well, the deep N-well being located in a first N-well, the second P-type heavily doped region and the second N-type heavily doped region both being located in a second N-well, and the first N-well and the second N-well both being located on the P-type substrate;
a first distance being provided between the first P-type heavily doped region and the first N-type heavily doped region, a second distance being provided between the first N-type heavily doped region and the second P-type heavily doped region, and a third distance being provided between the second P-type heavily doped region and the second N-type heavily doped region; and
the test structure being configured to test an electrical parameter of a latch-up effect of an integrated circuit corresponding to the test structure by adjusting at least one of the first distance, the second distance, and the third distance.

8. The integrated circuit latch-up test structure according to claim 7, wherein the second N-well, the P-type substrate and the deep N-well constitute a first parasitic NPN transistor; and
the second P-type heavily doped region, the second N-well and the P-type substrate constitute a first parasitic PNP transistor.

9. The integrated circuit latch-up test structure according to claim 8, wherein the P-type substrate has a first parasitic resistor, a first terminal of the first parasitic resistor being connected to the first P-type heavily doped region, a second terminal of the first parasitic resistor being connected to an emitter of the first parasitic NPN transistor; and
the second N-well has a second parasitic resistor, a first terminal of the second parasitic resistor being connected to the second N-type heavily doped region, and a second terminal of the second parasitic resistor being connected to a base of the first parasitic PNP transistor.

10. An integrated circuit latch-up test structure, comprising:
a first N-type heavily doped region, a first P-type heavily doped region, a second N-type heavily doped region, and a second P-type heavily doped region;
wherein the first N-type heavily doped region and the first P-type heavily doped region are both located in a deep N-well, the deep N-well being located in an N-well, and the N-well being located on a P-type substrate;
the second N-type heavily doped region and the second P-type heavily doped region are both located in a P-well, the P-well being located in the deep N-well;
a first distance being provided between the first N-type heavily doped region and the first P-type heavily doped region, a second distance being provided between the first P-type heavily doped region and the second N-type heavily doped region, and a third distance being provided between the second N-type heavily doped region and the second P-type heavily doped region; and
the test structure being configured to test an electrical parameter of a latch-up effect of an integrated circuit corresponding to the test structure by adjusting at least one of the first distance, the second distance, and the third distance.

11. The integrated circuit latch-up test structure according to claim 10, wherein the first P-type heavily doped region, the deep N-well and the second P-type heavily doped region constitute a first parasitic PNP transistor; and
the first N-type heavily doped region, the P-type substrate and the deep N-well constitute a first parasitic NPN transistor.

12. The integrated circuit latch-up test structure according to claim 11, wherein the deep N-well has a first parasitic resistor, a first terminal of the first parasitic resistor being connected to the first N-type heavily doped region, and a second terminal of the first parasitic resistor being connected to a base of the first parasitic PNP transistor; and
the P-well has a second parasitic resistor, a first terminal of the second parasitic resistor being connected to the second P-type heavily doped region, and a second terminal of the second parasitic resistor being connected to a base of the first parasitic NPN transistor and a collector of the first parasitic PNP transistor.

13. An integrated circuit latch-up test structure, comprising:
a first N-type heavily doped region, a first P-type heavily doped region, a second N-type heavily doped region, and a second P-type heavily doped region;
wherein the first N-type heavily doped region is located in an N-well, the N-well being located on a P-type substrate;
the first P-type heavily doped region being located in a P-well, the P-well being located in a deep N-well, and the deep N-well being located in the N-well;
the second N-type heavily doped region and the second P-type heavily doped region both being located on the P-type substrate;
a first distance being provided between the first N-type heavily doped region and the first P-type heavily doped region, a second distance being provided between the first P-type heavily doped region and the second N-type heavily doped region, and a third distance being provided between the second N-type heavily doped region and the second P-type heavily doped region; and
the test structure being configured to test an electrical parameter of a latch-up effect of an integrated circuit corresponding to the test structure by adjusting at least one of the first distance, the second distance, and the third distance.

14. The integrated circuit latch-up test structure according to claim 13, wherein the P-well, the deep N-well and the P-type substrate constitute a first parasitic PNP transistor; and
the deep N-well, the P-type substrate and the second N-type heavily doped region constitute a first parasitic NPN transistor.

15. The integrated circuit latch-up test structure according to claim 14, wherein the deep N-well has a first parasitic resistor, a first terminal of the first parasitic resistor being connected to the first N-type heavily doped region, and a second terminal of the first parasitic resistor being connected to a base of the first parasitic PNP transistor; and
the P-type substrate has a second parasitic resistor, a first terminal of the second parasitic resistor being connected to the second P-type heavily doped region, and a second terminal of the second parasitic resistor being connected to a base of the first parasitic NPN transistor and a collector of the first parasitic PNP transistor.

16. An integrated circuit latch-up test structure, comprising:
a first N-type heavily doped region, a first P-type heavily doped region, a second N-type heavily doped region, and a second P-type heavily doped region;
wherein the first N-type heavily doped region is located in a first N-well, the first N-well being located on a P-type substrate;
the first P-type heavily doped region being located in a P-well, the P-well being located in a deep N-well, and the deep N-well being located in the first N-well;
the second N-type heavily doped region being located in a second N-well, the second N-well being located on the P-type substrate;
the second P-type heavily doped region being located on the P-type substrate;
a first distance being provided between the first N-type heavily doped region and the first P-type heavily doped region, a second distance being provided between the first P-type heavily doped region and the second N-type heavily doped region, and a third distance being provided between the second N-type heavily doped region and the second P-type heavily doped region; and
the test structure being configured to test an electrical parameter of a latch-up effect of an integrated circuit corresponding to the test structure by adjusting at least one of the first distance, the second distance, and the third distance.

17. The integrated circuit latch-up test structure according to claim 16, wherein the P-well, the deep N-well and the P-type substrate constitute a first parasitic PNP transistor; and
the deep N-well, the P-type substrate and the second N-well constitute a first parasitic NPN transistor.

18. The integrated circuit latch-up test structure according to claim 17, wherein the deep N-well has a first parasitic resistor, a first terminal of the first parasitic resistor being connected to the first N-type heavily doped region, and a second terminal of the first parasitic resistor being connected to a base of the first parasitic PNP transistor; and
the P-type substrate has a second parasitic resistor, a first terminal of the second parasitic resistor being connected to the second P-type heavily doped region, and a second terminal of the second parasitic resistor being connected to a base of the first parasitic NPN transistor and a collector of the first parasitic PNP transistor.

19. An integrated circuit latch-up test structure, comprising:
a first N-type heavily doped region, a first P-type heavily doped region, a second N-type heavily doped region, and a second P-type heavily doped region;
wherein the first N-type heavily doped region is located in a first N-well, the first N-well being located on a P-type substrate;
the first P-type heavily doped region being located in a P-well, the P-well being located in a first deep N-well, and the first deep N-well being located in the first N-well;
the second N-type heavily doped region being located in a second deep N-well, the second deep N-well being located in a second N-well, the second N-well being located on the P-type substrate;
the second P-type heavily doped region being located on the P-type substrate;
a first distance being provided between the first N-type heavily doped region and the first P-type heavily doped region, a second distance being provided between the first P-type heavily doped region and the second N-type heavily doped region, and a third distance being provided between the second N-type heavily doped region and the second P-type heavily doped region; and
the test structure being configured to test an electrical parameter of a latch-up effect of an integrated circuit corresponding to the test structure by adjusting at least one of the first distance, the second distance, and the third distance.

20. The integrated circuit latch-up test structure according to claim 19, wherein the P-well, the first deep N-well and the P-type substrate constitute a first parasitic PNP transistor; and
the first deep N-well, the P-type substrate and the second deep N-well constitute a first parasitic NPN transistor.

21. The integrated circuit latch-up test structure according to claim 20, wherein the first deep N-well has a first parasitic resistor, a first terminal of the first parasitic resistor being connected to the first N-type heavily doped region, and a second terminal of the first parasitic resistor being connected to a base of the first parasitic PNP transistor; and
the P-type substrate has a second parasitic resistor, a first terminal of the second parasitic resistor being connected to the second P-type heavily doped region, and a second terminal of the second parasitic resistor being connected to a base of the first parasitic NPN transistor and a collector of the first parasitic PNP transistor.
